(19) Europäisches Patentamt
European Patent Office
Office européen des brevets

(11) **EP 2 073 263 A1**

(12) **EUROPEAN PATENT APPLICATION**
published in accordance with Art. 153(4) EPC

(43) Date of publication:
**24.06.2009 Bulletin 2009/26**

(51) Int Cl.:
*H01L 23/34* (2006.01)     *H05K 7/20* (2006.01)
*G06F 1/20* (2006.01)

(21) Application number: **07816993.5**

(22) Date of filing: **27.09.2007**

(86) International application number:
**PCT/CN2007/070802**

(87) International publication number:
**WO 2008/040255 (10.04.2008 Gazette 2008/15)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **28.09.2006 US 827222 P**
**15.06.2007 US 763630**

(71) Applicant: **Mediatek Inc.**
**Science-based Industrial Park**
**Hsin-chu City, Taiwan 300 (CN)**

(72) Inventors:
• **CHEN, Nancheng**
**Hsin-chu City, Taiwan (CN)**
• **CHANG, Chunwei**
**Danshui Town, Taipei Hsien, Taiwan (CN)**
• **TSENG, Chaowei**
**Chu-tung Town, Hsinchu Hsien, Taiwan (CN)**

(74) Representative: **Blasberg, Tilo et al**
**2K Patentanwälte Kewitz & Kollegen**
**Partnerschaft**
**Corneliusstrasse 18**
**60325 Frankfurt am Main (DE)**

(54) **ELECTRONIC DEVICE**

(57)     An electronic device (100) comprises case (110), printed circuit board (120), and chip (130). The printed circuit board (120) is disposed in the case (110), and has the first metal ground plate (121), the second metal ground plate (122), and metal connection member (123). The first metal ground plate (121) is opposed to the second metal ground plate (122). The metal connection member (123) is connected between the first metal ground plate (121) and the second metal ground plate (122). The second metal ground plate (122) is connected to the case (110). The chip (130) is electrically connected to the printed circuit board (120), and comprises die (131), and is bonded to the first metal ground plate (121). Heat generated by the chip (130) is conducted to the case (110) through the heat conducting member (132), the first metal ground plate (121), the metal connection member (123), and the second metal ground plate (122).

FIG. 2

**Description**

FIELD OF THE INVENTION

The invention relates to electronic devices, and more particularly to electronic devices with enhanced heat spread or dissipation From chips and electrostatic discharge protection therein.

BACKGROUND TECHNOLOGY

Generally, as performance of chips (integrated circuits) is promoted, heat generated thereby increases commensurately. Effective removal or spread of the heat generated by the chips (integrated circuits) during operation is thus critical.

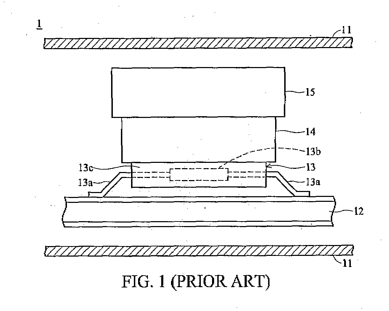

Referring to FIG. 1, a conventional electronic device I comprises a casing 11, a printed circuit board 12, a chip 13, a heat sink 14, and a fan 15. The printed circuit board 12, chip 13, heat sink 14, and fan 15 are disposed in the casing 11. The chip 13 is disposed on the printed circuit board 12 and may be a chip with lead-frame package or ball grid array package. Here, the chip 13 shown in FIG. 1 is illustrated by a chip with lead-frame package and comprises a plurality of leads 13a, a die 13b, and a molding plastic 13c. The die 13b is covered by the molding plastic 13c and is connected to the leads 13a. The leads 13a arc electrically connected to the printed printed circuit board 12 by soldering. The heat sink 14 is disposed on the chip 13. The fan 15 is disposed on the heat sink 14.

Heat generated by the die 13b of the chip 13, during operation, is transferred to the heat sink 14 through the molding plastic 13c. The heat is then dissipated to the interior or exterior of the casing 11 from the heat sink 14 by the lan 15.

The electronic device 1 as shown in FIG. 1, however, has many drawbacks regarding to heat spreading. A formula of thermal conduction is described as follows: $\frac{Q}{t} = \frac{k \times A \times \Delta T}{L}$, wherein, Q denotes conducted heat, t denotes conducted time, $\frac{Q}{t}$ denotes thermal conduction rate, k denotes a coefficient of thermal conduction, A denotes thermal contact area, $\Delta T$ denotes temperature difference, and L denotes conducted distance. In general, the temperature difference ($\Delta T$) between the chip 13 and the heat sink 14 is often insignificant and the value of the coefficient (k) of thermal conduction of the molding plastic 13c is quite small. Thus, the heat dissipation from the chip is poor because of the thermal conduction rate $\frac{Q}{(t)}$ at which the heat generated by the die 13b conducted to the heat sink 14 through the molding plastic 13c is low. Additionally, the current disposition of the heat sink 14 and fan 15 in the electronic device 1 is not only taking a large space from the device but also increasing the manufacturing costs. Another drawback of the current system is that the issues of electrostatic discharge (ESD). Usually, time, effort and test equipment are required for solving issues of electrostatic discharge (ESD), the manufacturing costs of the electronic device 1 is therefore increased.

Specially, the electronic device 1 has the same aforementioned drawbacks when the chip 13 is presented in the form of a ball grid array package.

CONTENT OF THE INVENTION

A detailed description is given in the following embodiments with reference to the accompanying drawings.

An exemplary embodiment of the invention provides an electronic device comprising a casing, a printed circuit board, and a chip. The printed circuit board is disposed in the casing and comprises a first metal ground layer, a second metal ground layer, and a metal connecting portion. The first metal ground layer is disposed on the printed circuit board opposite the second metal ground layer. The metal connecting portion is connected between the first and second metal ground layers. The second metal ground layer is connected to the casing. The chip is electrically connected to the printed circuit board and comprises a die and a heat-conducting portion connected to the die and soldered with the first metal ground layer. Heat generated by the chip is conducted to the casing through the heat-conducting portion, first metal ground layer, metal connecting portion, and second metal ground layer.

The invention provides another electronic device comprising a casing, a printed circuit board, a chip and a metal connecting member. The printed circuit board is disposed in the casing and comprises a first metal ground layer and a second metal ground layer opposite to the second metal ground layer. The chip is electrically connected to the printed circuit board and comprises a die and a heat-conducting portion connected to the die and soldered with the first metal ground layer. The metal connecting portion, fitted in the printed circuit board, connects the first and second metal ground layers to the casing. Heat generated by the chip is conducted to the casing through the heat-conducting portion, first metal ground layer and the metal connecting portion.

The invention provides another electronic device comprising a casing, a printed circuit board and a chip. The printed circuit board is disposed in the casing and comprises a metal ground layer connected to the casing. The chip is electrically connected to the printed circuit board and comprises a die and a heat-conducting portion connected to the die and soldered with the metal ground layer. Heat generated by the chip is conducted to the casing through the heat-conducting portion and metal ground layer.

The invention provides another electronic device comprising a casing, a printed circuit board and a chip. The printed circuit board is disposed in the casing. The chip is electrically connected to the printed circuit board and comprises a die and a heat-conducting portion connected between the die and the casing. Heat generated by the chip is conducted to the casing through the heat-conducting portion.

The electronic device of the invention utilizes the heat-conducting portion with aid of relevant components to conduct heat generated by the chip and the static generated by the printed circuit board to the casing, enhancing heat-spread efficiency of the chip and electrostatic discharge protection. Additionally, fins and fans can be eliminated in the electronic device, reducing size of the electronic device and manufacturing costs.

DESCRIPTION OF THE DRAWINGS

The invention can be more fully understood by reading the subsequent detailed description and examples with references made to the accompanying drawings, wherein:

FIG. 1 is a partial side view and cross section of a conventional electronic device;
FIG. 2 is a partial side view and cross section of an electronic device of a first embodiment of the invention;
FIG. 3 is a partial side view and cross section of an electronic device of a second embodiment of the invention;
FIG. 4 is a partial side view and cross section of an electronic device of a third embodiment of the invention;
FIG. 5 is a partial side view and cross section of an electronic device of a fourth embodiment of the invention;
FIG. 6 is a partial side view and cross section of an electronic device of a fifth embodiment of the invention;
FIG. 7 is a partial side view and cross section of an electronic device of a sixth embodiment of the invention;
FIG. 8 is a partial side view and cross section of an electronic device of a seventh embodiment of the invention; and
FIG. 9 is a partial side view and cross section of an electronic device of an eighth embodiment of the invention.

DETAILED DESCRIPTION OF THE EMBODIMENTS

The following description is of the best-contemplated mode of carrying out the invention.

FIRST EMBODIMENT

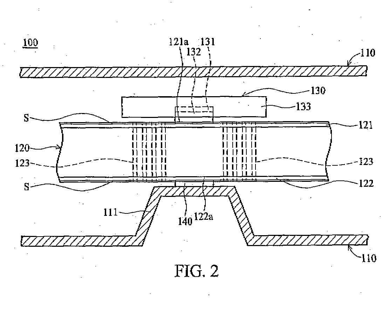

Referring to FIG. 2, an electronic device 100 comprises a casing 110, a printed circuit board 120, a chip 130, and a conductive element 140.

The printed circuit board 120 is disposed in the casing 110 and comprises a first metal ground layer 121, a second metal ground layer 122, and a plurality of metal connecting portions 123. The first metal ground layer 121 is disposed on the printed circuit board 120 opposite the second metal ground layer 122. The metal connecting portions 123 are respectively connected between the first metal ground layer 121 and the second metal ground layer 122. The second metal ground layer 122 is connected to the casing 110. In this embodiment, the casing 110 comprises a protrusion 111 to which the second metal ground layer 122 is connected. Moreover, each metal connecting portion 123 may be a through hole with an inner wall coated with metal. Additionally, the printed circuit board 120 may be a multilayer printed circuit board.

The chip 130 is electrically connected to the printed circuit board 120 and comprises a die 131, a heat-conducting portion 132, and a molding plastic 133. The heat-conducting portion 132 is connected to the die 131 and is soldered with the first metal ground layer 121 of the printed circuit board 120. The molding plastic 133 covers the die 131. Specifically, the first metal ground layer 121 is often coated with a solder mask S. To solder the heat-conducting portion 132 of the chip 130 with the first metal ground layer 121, the first metal ground layer 121 comprises a top solder mask opening 121a formed thereon. The heat-conducting portion 132 is soldered with the first metal ground layer 121 through the top solder mask opening 121a.

The conductive element 140 is connected between the protrusion 111 of the casing 110 and the second metal ground layer 122 of the printed circuit board 120. Similarly, the second metal ground layer 122 is often coated with a solder mask S. The second metal ground layer 122 comprises a bottom solder mask opening 122a formed thereon. The conductive element 140 is connected to the second metal ground layer 122 through the bottom solder mask opening 122a. Additionally, the conductive element 140 may comprise electric and/or thermal conductors. For example, the conductive element 140 may comprise conductive glue, a conductive tape, or a thermal pad.

Moreover, the chip 130 may be a chip with lead-frame package or ball grid array package. Specifically, when the chip 130 is a chip with lead-frame package, such as a chip with low profile plastic quad flat package (LQFP), the heat-conducting portion 132 thereof is an exposed die pad connected to the die 131. Here, the exposed die pad is composed of metal, such as aluminum. In another aspect, when the chip 130 is a chip with ball grid array package, such as a chip with flip chip ball grid array package (FCBGA package), the heat-conducting portion 132 thereof is formed by a plurality of thermal ground balls connected to the die 131.

When the die 131 of the chip 130 is in operation, heat generated thereby is conducted to the casing 110 sequentially through the heat-conducting portion 132, first metal ground layer 121, metal connecting portions 123, second metal ground layer 122, and conductive element 140 and is further transmitted to the exterior of the electronic device 100.

Accordingly, as the heat generated by the die 131 is not distributed over the molding plastic 133 but conducted to the casing 110 through the heat-conducting portion 132, first metal ground layer 121, metal connecting portions 123, second metal ground layer 122, and conductive element 140, the value of the coefficient (k) of thermal conduction is significantly increased. Additionally, the temperature difference ($\Delta$T) between the die 131 and the casing 110 is larger than the temperature difference between the die 131 and the molding plastic 133.

Thus, the thermal conduction rate $\frac{Q}{(t)}$ is increased and the ability of heat spread or dissipation from the die 131 (or chip 130) is enhanced. Moreover, neither a heat sink nor a fan is required for the disclosed electronic device. Thus, the overall size and manufacturing costs of the electronic device 100 are significantly reduced.

More specifically, as the first metal ground layer 121 is connected to the second metal ground layer 122 through a shortest conduction path (metal connecting portions 123) and the second metal ground layer 122 is connected to the casing 110, static electricity in the printed circuit board 120 is easily conducted to the casing 110, effectively enhancing electrostatic discharge (ESD) protection in the electronic device 100. Thus, time, effort, and test equipment for solving issues of electrostatic discharge (ESD) are not required, further reducing the manufacturing costs of the electronic device 100.

Moreover, the electronic device 100 may selectively omit the conductive element 140. Namely, the protrusion 111 of the casing 110 may be directly connected to the second metal ground layer 122 through the bottom solder mask opening 122a, achieving the effect described.

SECOND EMBODIMENT

Elements corresponding to those in the first embodiment share the same reference numerals.

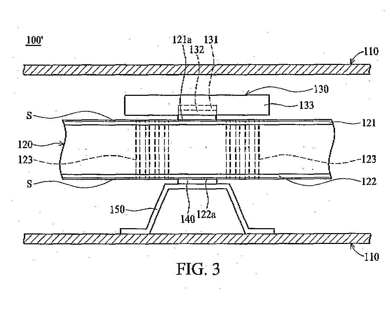

Referring to FIG. 3, the protrusion 111 of the electronic device 100 of the first embodiment is replaced by a conduction base 150 of an electronic device 100' in this embodiment. Specifically, the conduction base 150 is connected between the second metal ground layer 122 of the printed circuit board 120 and the casing 110 and may comprise electric and/or thermal conductors.

When the conduction base 150 comprises an electric conductor, such as metal, heat spread or dissipation from the die 131 (or chip 130) and electrostatic discharge (ESD) protection in the electronic device 100' are effectively enhanced. In another aspect, when the conduction base 150 comprises a thermal conductor, such as an insulating thermal pad, heat spread or dissipation from the die 131 (or chip 130) is effectively enhanced.

Similarly, the electronic device 100' may selectively omit the conductive element 140. Namely, the conduction base 150 may be directly connected to the second metal ground layer 122 through the bottom solder mask opening 122a, achieving the effect described.

Structure, disposition, and function of other elements in this embodiment are the same as those in the first embodiment, and explanation thereof is omitted for simplicity.

THIRD EMBODIMENT

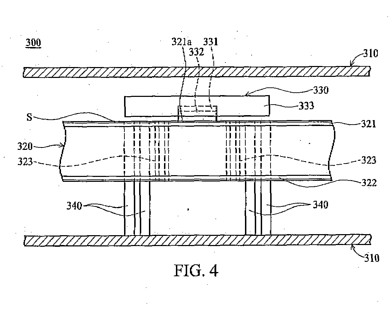

Referring to FIG. 4, an electronic device 300 comprises a casing 310, a printed circuit board 320, a chip 330, and a plurality of metal connecting members 340.

The printed circuit board 320 is disposed in the casing 310 and comprises a first metal ground layer 321, a second metal ground layer 322, and a plurality of metal connecting portions 323. The first metal ground layer 321 is opposite the second metal ground layer 322. The metal connecting portions 323 are respectively connected between the first metal ground layer 321 and the second metal ground layer 322. In this embodiment, each metal connecting portion 323 may be a through hole with an inner wall coated with metal. Additionally, the printed circuit board 320 may be a multilayer printed circuit board.

The chip 330 is electrically connected to the printed circuit board 320 and comprises a die 331, a heat-conducting portion 332, and a molding plastic 333. The heat-conducting portion 332 is connected to the die 331 and is soldered with the first metal ground layer 321 of the printed circuit board 320. The molding plastic 333 covers the die 331. Specifically, the first metal ground layer 321 is often coated with a solder mask S. To connect the heat-conducting portion 332 of the chip 330 with the first metal ground layer 321, the first metal ground layer 321 comprises a solder mask opening 321a formed thereon. The heat-conducting portion 332 is soldered with the first metal ground layer 321 through the solder mask opening 321a.

The metal connecting members 340 are fit in the printed circuit board 320 and connect the first metal ground layer 321 and second metal ground layer 322 to the casing 310. Specifically, the metal connecting members 340 may be screws fixing the printed circuit board 320 to the casing 310, in addition to connecting the first metal ground layer 321 and second metal ground layer 322 to the casing 310.

Similarly, the chip 330 may be a chip with lead-frame package or ball grid array package. When the chip 330 is a chip with lead-frame package, such as a chip with low profile plastic quad flat package (LQFP), the heat-conducting portion 332 thereof is an exposed die pad connected to the die 331. Here, the exposed die pad is composed of metal, such as aluminum. In another aspect, when the chip 330 is a chip with ball grid array package, such as a chip with flip chip ball grid array package (FCBGA package), the heat-conducting portion 332 thereof is formed by a plurality of thermal ground balls connected to the die 331.

When the die 331 of the chip 330 is in operation, heat generated thereby is conducted to the casing 310 through the heat-conducting portion 332, first metal ground layer 321, metal connecting portions 323, second metal ground layer 322, and metal connecting members 340 and is further transmitted to the exterior of the electronic device 300.

Accordingly, as the heat generated by the die 331 is not distributed over the molding plastic 333 but conducted to the casing 310 through the heat-conducting portion 332, first metal ground layer 321, metal connecting portions 323, second metal ground layer 322, and metal connecting members 340, the value of the thermal conduction coefficient (k) is significantly increased. Additionally, the temperature difference ($\Delta T$) between the die 331 and the casing 310 is larger than the temperature difference between the die 331 and the molding plastic 333. Thus, the thermal conduction rate $\frac{Q}{(t)}$ at which the heat generated by the die 331 is conducted to the casing 310 is high, enhancing heat spread or dissipation from the die 331 (or chip 330). Similarly, as neither a heat sink nor a fan is required, the overall size and manufacturing costs of the electronic device 300 arc significantly reduced.

More specifically, as the first metal ground layer 321 is connected to the second metal ground layer 322 through a shortest conduction path (metal connecting members 340 and metal connecting portions 323), and the second metal ground layer 322 is connected to the casing 310 through a shortest conduction path (metal connecting members 340), static electricity in the printed circuit board 320 is easily conducted to the casing 310, effectively enhancing electrostatic discharge (ESD) protection in the electronic device 300. Thus, time, effort, and test equipment for solving issues of electrostatic discharge (ESD) can be omitted, further reducing the manufacturing costs of the electronic device 300.

Moreover, the printed circuit board 320 may selectively omit the metal connecting portions 323. At this point, heat generated by the die 331 is conducted to the casing 310 through the heat-conducting portion 332, first metal ground layer 321, and metal connecting members 340 and is further transmitted to the exterior of the electronic device 300. Accordingly, heat spread or dissipation from the die 331 (or chip 330) and electrostatic discharge (ESD) protection in the electronic device 300 are also enhanced.

FOURTH EMBODIMENT

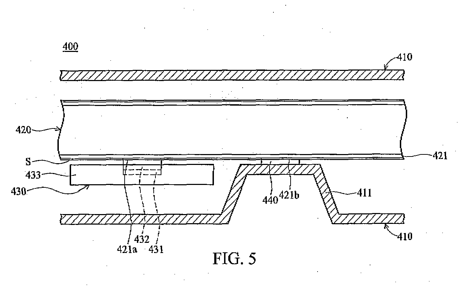

Referring to FIG. 5, an electronic device 400 comprises a casing 410, a printed circuit board 420, a chip 430, and a conductive element 440.

The printed circuit board 420 is disposed in the casing 410 and comprises a metal ground layer 421 connected to the casing 410. In this embodiment, the casing 410 comprises a protrusion 411 to which the metal ground layer 421 is connected. Additionally, the printed circuit board 420 may be a multilayer printed circuit board.

The chip 430 is electrically connected to the printed circuit board 420 and comprises a die 431, a heat-conducting portion 432, and a molding plastic 433. The heat-conducting portion 432 is connected to the die 431 and is soldered with the metal ground layer 421 of the printed circuit board 420. The molding plastic 433 covers the die 431.

Specifically, the metal ground layer 421 is often coated with a solder mask S. To connect the heat-conducting portion 432 of the chip 430 with the metal ground layer 421, the metal ground layer 421 comprises a top solder mask opening 421 a formed thereon. The heat-conducting portion 432 is soldered with the metal ground layer 421 through the top solder mask opening 421a.

The conductive element 440 is connected between the protrusion 411 of the casing 410 and the metal ground layer 421 of the printed circuit board 420. Specifically, the metal ground layer 421 further comprises a bottom solder mask opening 421b formed thereon. The conductive element 440 is soldered with the metal ground layer 421 through the bottom solder mask opening 421b. Additionally, the conductive element 440 may comprise electric and/or thermal conductors. For example, the conductive clement 440 may comprise conductive glue, a conductive tape, or a thermal pad.

Similarly, the chip 430 may be a chip with lead-frame package or ball grid array package. When the chip 430 is a chip with lead-frame package, such as a chip with low profile plastic quad flat package (LQFP), the heat-conducting portion 432 thereof is an exposed die pad connected to the die 431. Here, the exposed die pad is composed of metal, such as aluminum. In another aspect, when the chip 430 is a chip with ball grid array package, such as a chip with flip chip ball grid array package (FCBGA package), the heat-conducting portion 432 thereof is formed by a plurality of thermal ground balls connected to the die 431.

When the die 431 of the chip 430 is in operation, heat generated thereby is conducted to the casing 410 sequentially through the heat-conducting portion 432, metal ground layer 421, and conductive element 440 and is further transmitted to the exterior of the electronic device 400.

Accordingly, as the heat generated by the die 431 is not distributed over the molding plastic 433 but conducted to the casing 410 through the heat-conducting portion 432, metal ground layer 421, and conductive element 440, the value of the thermal conduction coefficient (k) is significantly increased comparing to the traditional packaging structure. Additionally, the tempera-

ture difference ($\Delta$T) between the die 431 and the casing 410 is larger than the temperature difference between the die 431 and the molding plastic 433. Thus, the thermal conduction rate $\frac{Q}{(t)}$ at which the heat generated by the die 431 distributing over the casing 410 has a higher conducting rate than traditional devices, and thus the efficiency of heat spread or dissipation from the die 431 (or chip 430) is improved. As disclosed, neither a heat sink nor a fan is required, the overall size and manufacturing costs of the electronic device 400 are significantly reduced.

More specifically, as the metal ground layer 421 is connected to the casing 410 through a shortest conduction path, static electricity in the printed circuit board 420 is easily transmitted to the casing 410, effectively enhancing electrostatic discharge (ESD) protection in the electronic device 400. Thus, time, effort, and test equipment for solving issues of electrostatic discharge (ESD) can be omitted, further reducing the manufacturing costs of the electronic device 400.

Moreover, the electronic device 400 may selectively omit the conductive element 440. Namely, the protrusion 411 of the casing 410 may be directly connected to the metal ground layer 421 through the bottom solder mask opening 421b, achieving the effect described.

## FIFTH EMBODIMENT

Elements corresponding to those in the fourth embodiment share the same reference numerals.

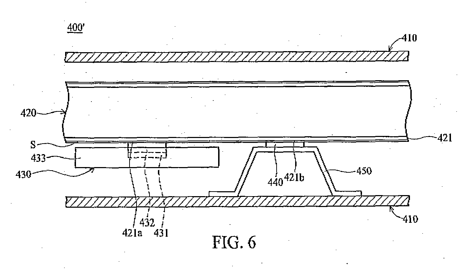

Referring to FIG. 6, the protrusion 411 of the electronic device 400 of the fourth embodiment is replaced by a conduction base 450 of an electronic device 400' in this embodiment. Specifically, the conduction base 450 is connected between the metal ground layer 421 of the printed circuit board 420 and the casing 410, and it may comprise electric and/or thermal conductors.

When the conduction base 450 comprises an electric conductor, such as metal, heat spread or dissipation from the die 431 (or chip 430) and electrostatic discharge (ESD) protection in the electronic device 400' are effectively enhanced. In another aspect, when the conduction base 450 comprises a thermal conductor, such as an insulating thermal pad, heat spread or dissipation from the die 431 (or chip 430) is effectively enhanced.

Similarly, the electronic device 400' may selectively omit the conductive element 440. Namely, the conduction base 450 may be directly connected to the metal ground layer 421 through the bottom solder mask opening 421 b, achieving the effect described.

Structure, disposition, and function of other elements in this embodiment are the same as those in the fourth embodiment, and explanation thereof is omitted for simplicity.

## SIXTH EMBODIMENT

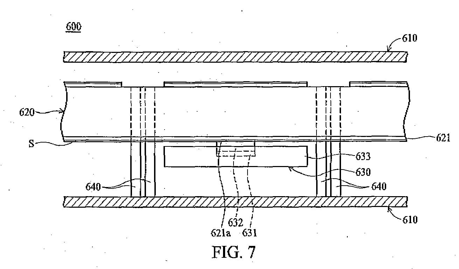

Referring to FIG. 7, an electronic device 600 comprises a casing 610, a printed circuit board 620, a chip 630, and a plurality of metal connecting members 640.

The printed circuit board 620 is disposed in the casing 610 and comprises a metal ground layer 621. Additionally, the printed circuit board 620 may be a multilayer printed circuit board.

The chip 630 is electrically connected to the printed circuit board 620 and comprises a die 631, a heat-conducting portion 632, and a molding plastic 633. The heat-conducting portion 632 is connected to the die 631 and is soldered with the metal ground layer 621 of the printed circuit board 620. The molding plastic 633 covers the die 631. Specifically, the metal ground layer 621 is often coated with a solder mask S. To connect the heat-conducting portion 632 of the chip 630 with the metal ground layer 621, the metal ground layer 621 comprises a solder mask opening 621a formed thereon. The heat-conducting portion 632 is soldered with the metal ground layer 621 through the solder mask opening 621 a.

The metal connecting members 640 are fit in the printed circuit board 620 and connect the metal ground layer 621 to the casing 610. Specifically, the metal connecting members 640 may be screws fixing the printed circuit board 620 to the casing 610, in addition to connecting the metal ground layer 621 to the casing 610.

Similarly, the chip 630 may be a chip with lead-frame package or ball grid array package. When the chip 630 is a chip with lead-frame package, such as a chip with low profile plastic quad flat package (LQFP), the heat-conducting portion 632 thereof is an exposed die pad connected to the die 631. Here, the exposed die pad is composed of metal, such as aluminum. In another aspect, when the chip 630 is a chip with ball grid array package, such as a chip with flip chip ball grid array package (FCBGA package), the heat-conducting portion 632 thereof is formed by a plurality of thermal ground balls connected to the die 631.

When the die 631 of the chip 630 is in operation, heat generated thereby is transmitted to the casing 610 through the heat-conducting portion 632, metal ground layer 621, and metal connecting members 640 and is further transmitted to the exterior of the electronic device 600.

Accordingly, as the heat generated by the die 631 is not distributed over the molding plastic 633 but conducted to the casing 610 through the heat-conducting portion 632, metal ground layer 621, and metal connecting members 640, the value of the thermal conduction coefficient (k) is significantly increased. Additionally, the temperature difference ($\Delta$T) between the die 631 and the casing 610 is larger than the temperature difference between the die 631 and the molding plastic 633. Thus, the

thermal conduction rate $\left(\frac{Q}{t}\right)$ is increased, and the heat spread or dissipation from the die 631 (or chip 630) is enhanced as well. The embodiment as disclosed requires neither a heat sink nor a fan. Thus, the overall size and manufacturing costs of the electronic device 600 arc significantly reduced.

More specifically, as the metal ground layer 621 is connected to the casing 610 through a shortest conduction path (metal connecting members 640), static electricity in the printed circuit board 620 is easily conducted to the casing 610, effectively enhancing electrostatic discharge (ESD) protection in the electronic device 600. Thus, time, effort, and test equipment for solving issues of electrostatic discharge (ESD) are not required, and the manufacturing costs of the electronic device 600 are further reduced as well.

SEVENTH EMBODIMENT

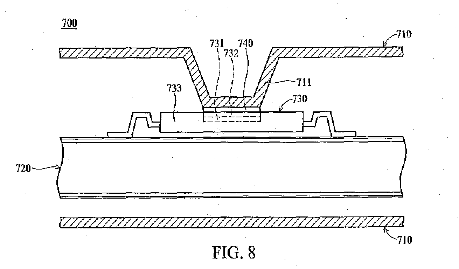

Referring to FIG. 8, an electronic device 700 comprises a casing 710, a printed circuit board 720, a chip 730, and a conductive element 740.

The casing 710 comprises a protrusion 711. The printed circuit board 720 is disposed in the casing 710. Additionally, the printed circuit board 720 may be a multilayer printed circuit board.

The chip 730 is electrically connected to the printed circuit board 720 and comprises a die 731, a heat-conducting portion 732, and a molding plastic 733. The heat-conducting portion 732 is connected between the die 731 and the protrusion 711 of the casing 710. The molding plastic 733 covers the die 731. Specifically, the chip 730 of this embodiment is a chip with lead-frame package and the heat-conducting portion 732 thereof is a reverse exposed die pad connected to the die 731. Here, the reverse exposed die pad is composed of metal, such as aluminum.

The conductive element 740 is connected between the protrusion 711 of the casing 710 and the heat-conducting portion 732. Additionally, the conductive element 740 may comprise electric and/or thermal conductors. For example, the conductive element 740 may comprise conductive glue, a conductive tape, or a thermal pad.

When the die 731 of the chip 730 is in operation, heat generated thereby is conducted to the casing 710 through the heat-conducting portion 732 and conductive element 740 and is further transmitted to the exterior of the electronic device 700.

Since the heat generated by the die 731 is not conducted to the molding plastic 733 but conducted to the casing 710 through the heat-conducting portion 732 and conductive element 740, the value of the coefficient (k) of thermal conduction is significantly increased. Additionally, the temperature difference ($\Delta$T) between the die 731 and the casing 710 is also increased. Thus, the

thermal conduction rate $\left(\frac{Q}{t}\right)$ at which the heat generated by the die 731 conducting to the casing 710 is increased, and the heat spread or dissipation from the die 731 (or chip 730) is enhanced. The embodiment as disclosed requires neither a heat sink nor a fan. Thus, the overall size and manufacturing costs of the electronic device 700 are significantly reduced.

Moreover, when the conductive element 740 comprises conductive glue or a conductive tape, static electricity in the printed circuit board 720 is easily conducted to the casing 710, effectively enhancing electrostatic discharge (ESD) protection in the electronic device 700. Thus, time, effort, and test equipment for solving issues of electrostatic discharge (ESD) are not required, further reducing the manufacturing costs of the electronic device 700.

Moreover, the electronic device 700 may selectively omit the conductive element 740. Namely, the protrusion 711 of the casing 710 may be directly connected to the heat-conducting portion 732, achieving the effect described.

EIGHTH EMBODIMENT

Elements corresponding to those in the seventh embodiment share the same reference numerals.

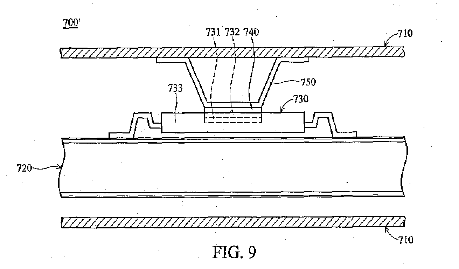

Referring to FIG. 9, the protrusion 711 of the electronic device 700 of the seventh embodiment is replaced by a conduction base 750 of an electronic device 700' in this embodiment. Specifically, the conduction base 750 is connected between the heat-conducting portion 732 and the casing 710 and may comprise electric and/or thermal conductors.

Specifically, when the conduction base 750 comprises an electric conductor, such as metal, heat spread or dissipation from the die 731 (or chip 730) and electrostatic discharge (ESD) protection in the electronic device 700' are effectively enhanced. In another aspect, when the conduction base 750 comprises a thermal conductor, such as an insulating thermal pad, heat spread or dissipation from the die 731 (or chip 730) is effectively enhanced.

Similarly, the electronic device 700' may selectively omit the conductive element 740. Namely, the conduction base 750 may be directly connected to the heat-conducting portion 732, achieving the effect described.

Structure, disposition, and function of other elements in this embodiment are the same as those in the seventh embodiment, and explanation thereof is omitted for simplicity.

While the invention has been described by way of example and in terms of preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation so as to encompass all such modifications and similar arrangements.

**Claims**

1. An electronic device, it **characterizing in that** the electronic device comprises:

   a casing;
   a printed circuit board, disposed in the casing, comprising a first metal ground layer, a second metal ground layer, and a metal connecting portion, wherein the first metal ground layer is opposite the second metal ground layer, the metal connecting portion is connected between the first and second metal ground layers, and the second metal ground layer is connected to the casing; and
   a chip, electrically connected to the printed circuit board, comprising a die and a heat-conducting portion, wherein the heat-conducting portion is connected to the die and soldered with the first metal ground layer,
   wherein heat generated by the chip is conducted to the casing through the heat-conducting portion, the first metal ground layer, the metal connecting portion, and the second metal ground layer.

2. The electronic device as claimed in claim 1, it **characterizing in that** the electronic device further comprises a conductive element connected between the casing and the second metal ground layer.

3. The electronic device as claimed in claim 2, it **characterizing in that** the conductive element comprises conductive glue, a conductive tape, or a thermal pad.

4. The electronic device as claimed in claim 1, it **characterizing in that** the first metal ground layer comprises a top solder mask opening through which the heat-conducting portion is soldered with the first metal ground layer.

5. The electronic device as claimed in claim 2, it **characterizing in that** the second metal ground layer comprises a bottom solder mask opening through which the conductive element is connected to the second metal ground layer.

6. The electronic device as claimed in claim 1, it **characterizing in that** the metal connecting portion comprises a through hole with an inner wall coated with metal.

7. The electronic device as claimed in claim 1, it **characterizing in that** the casing comprises a protrusion to which the second metal ground layer is connected.

8. The electronic device as claimed in claim 1, it **characterizing in that** the electronic device further comprises a conduction base connected between the second metal ground layer and the casing.

9. The electronic device as claimed in claim 1, it **characterizing in that** the chip comprises a chip with lead-frame package, and the heat-conducting portion comprises an exposed die pad.

10. The electronic device as claimed in claim 1, it **characterizing in that** the chip comprises a chip with ball grid array package, and the heat-conducting portion comprises a thermal ground ball.

11. An electronic device, it **characterizing in that** the electronic device comprises:

    a casing;
    a printed circuit board, disposed in the casing, comprising a first metal ground layer and a second metal ground layer opposite the first metal ground layer;
    a chip electrically, connected to the printed circuit board, comprising a die and a heat-conducting portion connected to the die and soldered with the first metal ground layer; and
    a metal connecting member, fitted in the printed circuit board, connecting the first and second metal ground layers to the casing,

    wherein heat generated by the chip is conducted to the casing through the heat-conducting portion, the first metal ground layer, and the metal connecting member.

12. The electronic device as claimed in claim 11, it **characterizing in that** the first metal ground layer comprises a solder mask opening through which the heat-conducting portion is soldered with the first metal ground layer.

13. The electronic device as claimed in claim 11, it **characterizing in that** the printed circuit board further comprises a metal connecting portion connected between the first and second metal ground layers, and the heat generated by the chip is conducted to the casing through the heat-conducting portion, first metal ground layer, metal connecting portion, second metal ground layer, and metal connecting member.

14. The electronic device as claimed in claim 13, it **characterizing in that** the metal connecting portion comprises a through hole with an inner wall coated with metal.

15. The electronic device as claimed in claim 11, it **characterizing in that** the chip comprises a chip with lead-frame package, and the heat-conducting portion comprises an exposed die pad.

16. The electronic device as claimed in claim 11, it **characterizing in that** the chip comprises a chip with ball grid array package, and the heat-conducting portion comprises a thermal ground ball.

17. An electronic device, it **characterizing in that** the electronic device comprises:

a casing;
a printed circuit board disposed in the casing and comprising a metal ground layer connected to the casing; and
a chip electrically connected to the printed circuit board and comprising a die and a heat-conducting portion connected to the die and soldered with the metal ground layer,

wherein heat generated by the chip is conducted to the casing through the heat-conducting portion and the metal ground layer.

18. The electronic device as claimed in claim 17, it **characterizing in that** the electronic device further comprises a conductive element connected between the casing and the metal ground layer.

19. The electronic device as claimed in claim 18, it **characterizing in that** the conductive element comprises conductive glue, a conductive tape, or a thermal pad.

20. The electronic device as claimed in claim 17, it **characterizing in that** the metal ground layer comprises a top solder mask opening through which the heat-conducting portion is soldered with the metal ground layer.

21. The electronic device as claimed in claim 18, it **characterizing in that** the metal ground layer further comprises a bottom solder mask opening through which the conductive element is connected to the metal ground layer.

22. The electronic device as claimed in claim 17, wherein the casing comprises a protrusion to which the metal ground layer is connected.

23. The electronic device as claimed in claim 17, it **characterizing in that** the electronic device further comprises a conduction base connected between the metal ground layer and the casing.

24. The electronic device as claimed in claim 17, it **characterizing in that** the chip comprises a chip with lead-frame package, and the heat-conducting portion comprises an exposed die pad.

25. The electronic device as claimed in claim 17, it **characterizing in that** the chip comprises a chip with ball grid array package, and the heat-conducting portion comprises a thermal ground ball.

26. An electronic device, it **characterizing in that** the electronic device comprises:

a casing;
a printed circuit board disposed in the casing and comprising a metal ground layer;
a chip electrically connected to the printed circuit board and comprising a die and a heat-conducting portion connected to the die and soldered with the metal ground layer; and
a metal connecting member fit in the printed circuit board and connecting the metal ground layer to the casing, wherein heat generated by the chip is conducted to the casing through the heat-conducting portion, the metal ground layer, and the metal connecting member.

27. The electronic device as claimed in claim 26, it **characterizing in that** the metal ground layer comprises a solder mask opening through which the heat-conducting portion is soldered with the metal ground layer.

28. The electronic device as claimed in claim 26, it **characterizing in that** the chip comprises a chip with lead-frame package, and the heat-conducting portion comprises an exposed die pad.

29. The electronic device as claimed in claim 26, it **characterizing in that** the chip comprises a chip with ball grid array package, and the heat-conducting portion comprises a thermal ground ball.

30. An electronic device, it **characterizing in that** the electronic device comprises:

a casing;
a printed circuit board disposed in the casing; and
a chip electrically connected to the printed circuit board and comprising a die and a heat-conducting portion connected between the die and the casing,

wherein heat generated by the chip is conducted to the casing through the heat-conducting portion.

**31.** The electronic device as claimed in claim 30, it **characterizing in that** the electronic device further comprises a conductive element connected between the casing and the heat-conducting portion.

**32.** The electronic device as claimed in claim 31, it **characterizing in that** the conductive element comprises conductive glue, a conductive tape, or a thermal pad.

**33.** The electronic device as claimed in claim 30, it **characterizing in that** the casing comprises a protrusion to which the heat-conducting portion is connected.

**34.** The electronic device as claimed in claim 30, it **characterizing in that** the electronic device further comprises a conduction base connected between the heat-conducting portion and the casing.

**35.** The electronic device as claimed in claim 30, it **characterizing in that** the chip comprises a chip with lead-frame package, and the heat-conducting portion comprises a reverse exposed die pad.

FIG. 1 (PRIOR ART)

FIG. 2

FIG. 3

FIG. 4

FIG. 5

FIG. 6

FIG. 7

FIG. 8

FIG. 9

## INTERNATIONAL SEARCH REPORT

| International application No. |
|---|
| PCT/CN2007/070802 |

**A. CLASSIFICATION OF SUBJECT MATTER**

**See extra sheet**

According to International Patent Classification (IPC) or to both national classification and IPC

**B. FIELDS SEARCHED**

Minimum documentation searched (classification system followed by classification symbols)

H01L23/-, H01L21/-, H05K7/20, G06F1/20

Documentation searched other than minimum documentation to the extent that such documents are included in the fields searched

Electronic data base consulted during the international search (name of data base and, where practicable, search terms used)

CPRS , CNKI,WPI,EPODOC,PAJ,TXTWO1,TXTGB1,TXTEP1 AND KEYWORD:

PCB, chip, heat, thermal, hole, case

**C. DOCUMENTS CONSIDERED TO BE RELEVANT**

| Category* | Citation of document, with indication, where appropriate, of the relevant passages | Relevant to claim No. |
|---|---|---|
| X | US 5467251 A (NORTHERN TELECOM LIMITED(CA))    14 November 1995(14.11.1995) line 59 of column 4 to line 48 of column 5 of description and figures 1-3 | 1-16,26-29 |
| Y | | 17-25 |
| Y | CN 1728377 A (VIA-TECH INC(TW)) 01 February 2006 (01.02.2006) line 21 of page 4 to line 20 of page 5 of description and figures 3A and 3B | 17-25 |
| X | CN 1627507 A (XITONG TECH CO LTD (TW)) 15 June 2005 (15.06.2005) line 20 of page 4 to line 8 of page 7 of description and figures 1-8 | 30-35 |
| A | US 6335862 B1 (NEC(JP)) 01 January 2002 (01.01.2002) columns 3-4 of description | 1-35 |

☐ Further documents are listed in the continuation of Box C.          ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim (S) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 21 November 2007 (21.11.2007) | **27 Dec. 2007 (27.12.2007)** |
| Name and mailing address of the ISA/CN The State Intellectual Property Office, the P.R.China 6 Xitucheng Rd., Jimen Bridge, Haidian District, Beijing, China 100088 Facsimile No. 86-10-62019451 | Authorized officer  FANG, Hualong  Telephone No. (86-10)62086325 |

Form PCT/ISA/210 (second sheet) (April 2007)

# EP 2 073 263 A1

| INTERNATIONAL SEARCH REPORT<br>Information on patent family members | | International application No.<br>PCT/CN2007/070802 | |
|---|---|---|---|
| Patent Documents referred in the Report | Publication Date | Patent Family | Publication Date |
| US5467251 A | 14.11.1995 | US5661902 A | 02.09.1997 |
| CN1728377 A | 01.02.2006 | NONE | |
| CN1627507 A | 15.06.2005 | NONE | |
| US6335862 B1 | 01.01.2002 | JP2001144449 A | 25.05.2001 |
| | | JP3573034 B2 | 06.10.2004 |

Form PCT/ISA/210 (patent family annex) (April 2007)

21

## INTERNATIONAL SEARCH REPORT

| International application No. |
| --- |
| PCT/CN2007/070802 |

CLASSIFICATION OF SUBJECT MATTER

H01L23/34 (2006.01) i

H05K7/20 (2006.01) i

G06F1/20 (2006.01) i

Form PCT/ISA/210 (extra sheet) (April 2007)